Europäisches Patentamt

European Patent Office

Office européen des brevets

(19)

(11) **EP 1 503 324 A1**

(12) **EUROPEAN PATENT APPLICATION**

(43) Date of publication:
**02.02.2005 Bulletin 2005/05**

(51) Int Cl.$^7$: **G06K 9/00**

(21) Application number: **04254387.6**

(22) Date of filing: **22.07.2004**

(84) Designated Contracting States:
**AT BE BG CH CY CZ DE DK EE ES FI FR GB GR
HU IE IT LI LU MC NL PL PT RO SE SI SK TR**
Designated Extension States:
**AL HR LT LV MK**

(30) Priority: **29.07.2003 JP 2003203012**

(71) Applicant: **Alps Electric Co., Ltd.
Tokyo 145 (JP)**

(72) Inventors:
• **Umeda, Yuichi, c/o Alps Electric Co., Ltd.
Ota-ku, Tokyo (JP)**
• **Saito, Junichi, c/o Alps Electric Co., Ltd.
Ota-ku, Tokyo (JP)**

(74) Representative: **Kensett, John Hinton
Saunders & Dolleymore,
9 Rickmansworth Road
Watford, Hertfordshire WD18 0JU (GB)**

(54) **Capacitance detector, method of detecting capacitance, and fingerprint sensor**

(57) A capacitance detector, used in an area sensor having a matrix of detection lines, detects minute capacitances near intersections of a plurality of column lines and a plurality of row lines. The capacitance detector includes a column-line driver for outputting to the column lines a signal that rises in response to a first voltage and then falls in response to a second voltage; a row-voltage outputter for outputting a third voltage corresponding to a current for charging the capacitance at each of the intersections when the column lines are driven by the first voltage and for outputting a fourth voltage corresponding to a current for discharging the capacitance at each of the intersections when the column lines are driven by the second voltage; and a calculator for calculating the difference between the third voltage and the fourth voltage. The difference is calculated at each of the intersections.

FIG. 1

## Description

BACKGROUND OF THE INVENTION

1. Field of the Invention

The present invention relates to a capacitance detector for detecting minute capacitances, a method of detecting capacitances, and a fingerprint sensor including the capacitance detector.

2. Description of the Related Art

As fingerprint sensors, which appear most promising in biometrics (living-body authentication technology), pressure-sensitive capacitive sensors have been developed. In these pressure-sensitive capacitive sensors, two films are opposed to each other at a predetermined distance with an insulating film sandwiched therebetween. Column lines and row lines are formed on the respective surface of the two films at predetermined intervals. With this pressure-sensitive capacitive sensor, the form of the films vary in accordance with the form of the fingerprint of a finger that is placed on the sensor and the distance between the column lines and the row lines is varied in some portions. The form of the fingerprint is detected as capacitances at intersections of the column lines and the row lines. Known technologies, applicable to this pressure-sensitive capacitive sensor, for detecting capacitances that are less than a few hundred femtofarads include a detector for converting a capacitance into an electrical signal by using switched capacitor circuits. In this detector, a sensor capacitive element, which is driven by a first sensor-driving signal and which detects a target capacitance, and a reference capacitive element, which is driven by a second sensor-driving signal and which generates a reference capacitance of the detector, are connected to a common switched capacitor circuit. First and second sample-and-hold circuits, which alternately operate, sample signals output from the switched capacitor circuit and calculate the difference between the sampled results to provide a detection signal.

Since a capacitance Cs to be detected is inversely proportional to a feedback capacitance Cf in the common switched capacitor circuit in the detector, it is possible to achieve stable detection. In addition, the effect of leakage (feedthrough) of an electric charge Qd, accumulated in a parasitic capacitance between the gate electrode and another electrode of a reset switch (feedback control switch) in the switched capacitor circuit, into the other electrodes can be offset. Furthermore, it is expected that an offset component of a reference voltage in the switched capacitor circuit and low-frequency noise included in an input signal or the like can be inhibited to some extent by calculating the difference between the two sampling results (for example, Japanese Unexamined Patent Application Publication No. 8-145717, which is equivalent to USP 5,633,594, paragraphs 0018 to 0052 and Figs. 1 to 4).

However, the known detector described above is designed for stably detecting a variation in one capacitance. Accordingly, there are problems when the above detector is applied to, for example, an area sensor, in which a plurality of column lines and a plurality of row lines are arranged in a matrix, to detect minute capacitances near intersections of the column lines and the row lines.

Specifically, a resolution of around 50 $\mu$m is required for a fingerprint sensor, and the capacitance Cs and its variation $\Delta$Cs at the intersections of column lines and the row lines have minute values that are less than a few hundred femtofarads. Hence, it is difficult to stably generate a reference capacitance Cr, which is required to be substantially equal to the capacitance Cs to be detected, without errors. Since the detection signal is affected by a variation in the reference capacitance Cr or the like, a detection signal having a sufficient S/N ratio cannot be generated.

In a matrix sensor, it is necessary to connect a plurality of row lines to the corresponding switched capacitor circuits and the corresponding reference capacitances Cr. With this structure, since variation is caused between the multiple reference capacitances Cr connected to the row lines intersecting with one column line, it is difficult to use each of the reference capacitances Cr as a standard capacitance in the entire detecting system.

SUMMARY OF THE INVENTION

Accordingly, in order to solve the problems described above, it is an object of the present invention to provide a capacitance detector in which an offset can be corrected by using differential operation without using a reference capacitance Cr, which can cause measurement errors, to reliably detect an output voltage corresponding to a minute capacitance, a method of detecting capacitances, and a fingerprint sensor including the detector.

The present invention provides, in its first aspect, a capacitance detector, used in an area sensor having a matrix of detection lines in which a plurality of column lines and a plurality of row lines are opposed to each other in a matrix form, for detecting minute capacitances near intersections of the column lines and the row lines. The capacitance detector includes a column-line driver for outputting to the column lines a signal that rises in response to a first voltage and then falls in response to a second voltage; a row-voltage outputter for outputting a third voltage corresponding to a current for charging the capacitance at each of the intersections when the column lines are driven by the first voltage and for outputting a fourth voltage corresponding to a current for discharging the capacitance at each of the intersections when the column lines are driven by the second voltage; and a calculator for calculating the difference between the third voltage and the fourth voltage output from the row-voltage outputter. The difference between the third voltage and the fourth voltage is calculated at each of the intersections where the column lines intersect with the row lines.

With this structure, since the difference between the output voltage at charge and the output voltage at discharge is calculated, the effect of a discharge current caused by feedthrough, which is always superimposed on the capacitances at the intersections at a predetermined direction with respect to the charge and discharge currents, can offset.

The present invention provides, in its second aspect, a capacitance detector, used in an area sensor having a matrix of detection lines in which a plurality of column lines and a plurality of row lines are opposed to each other in a matrix form, for detecting minute capacitances near intersections of the column lines and the row lines. The capacitance detector includes a column-line driver for sequentially outputting to the column lines signals that rise in response to a first voltage and then fall in response to a second voltage; a row-voltage outputter, provided for each of the column lines, for outputting a third voltage corresponding to a current for charging the capacitance at each of the intersections when the column lines are driven by the first voltage and for outputting a fourth voltage corresponding to a current for discharging the capacitance at each of the intersections when the column lines are driven by the second voltage; a holder, provided correspondingly to the row-voltage outputter, for holding the voltage output from the row-voltage outputter; a selector for sequentially selecting outputs from the holder to output the selected outputs; an analog-to-digital converter for converting the outputs from the selector into digital data; and a calculator for storing the digital data supplied from the analog-to-digital converter and calculating the difference between the third voltage and the fourth voltage at each of the intersections of the column lines and the row lines based on the stored data.

With this structure, the signals to be detected are sequentially supplied to the multiple column lines. The measured data for the target row line is stored, the stored data is sequentially selected, and the selected data is converted into the digital data. The data is processed concurrently with the detection of the capacitances, so that it is possible to efficiently process the measured data.

It is preferable that the capacitance detector further include a maximum-value finder for finding a maximum value in the third and fourth voltages detected at the intersections; a reference setter for setting the difference between the third voltage and the fourth voltage at each of the intersections as a reference voltage in a storage unit if the maximum value found by the maximum-value finder is smaller than a predetermined value set in advance; and a corrector for subtracting the reference voltage in the storage unit from the difference between the third voltage and the fourth voltage at each of the intersections and for outputting the subtraction result as data after offset correction.

With this structure, if the maximum value found by the maximum-value finder is smaller than a predetermined value, it is determined that a finger is not placed on the capacitance detector and the maximum value is stored as an offset value. If the maximum value is larger than the predetermined value, it is determined that a finger is placed on the capacitance detector and the offset value is corrected by using the maximum value. Accordingly, a variation in the capacitance when a finer is placed on the capacitance detector can be reliably detected.

It is preferable that the capacitance detector further include a maximum-value finder for finding a maximum value in the third and fourth voltages detected at the intersections; an amplifier for amplifying the third voltage and the fourth voltage at each of the intersections and outputting the amplified voltage; and a gain adjuster for increasing a gain for use in amplifying the third voltage and the fourth voltage at each of the intersections if the maximum value found by the maximum-value finder is smaller than a predetermined value set in advance and for decreasing the gain for use in amplifying the third voltage and the fourth voltage at each of the intersections if the maximum value found by the maximum-value finder is larger than another predetermined value set in advance.

As a characteristic of a fingerprint sensor, the level of the detected signal when a finger is pressed with a high pressure is different from the level thereof when a finger is pressed with a low pressure. Since the contrast of the data between peaks and troughs is important in a fingerprint sensor, the gain of entire detecting system is increased when the level of the detected signal is low to adjust the contrast of the measured data. Accordingly, it is possible to enhance the contrast of the measured data even when low-level signals are detected.

The present invention provides, in its third aspect, a fingerprint sensor including a capacitance detector used in an area sensor having a matrix of detection lines in which a plurality of column lines and a plurality of row lines are opposed to each other in a matrix form. The capacitance detector detects minute capacitances near intersections of the column lines and the row lines. The capacitance detector includes a column-line driver for outputting to the column lines a signal that rises in response to a first voltage and then falls in response to a second voltage; a row-voltage outputter for outputting a third voltage corresponding to a current for charging the capacitance at each of the intersections when the column lines are driven by the first voltage and for outputting a fourth voltage corresponding to a current for discharging the capacitance at each of the intersections when the column lines are driven by the second voltage;

and a calculator for calculating the difference between the third voltage and the fourth voltage output from the row-voltage outputter. The difference between the third voltage and the fourth voltage is calculated at each of the intersections where the column lines intersect with the row lines.

The present invention provides, in its fourth aspect, a fingerprint sensor including a capacitance detector used in an area sensor having a matrix of detection lines in which a plurality of column lines and a plurality of row lines are opposed to each other in a matrix form. The capacitance detector detects minute capacitances near intersections of the column lines and the row lines. The capacitance detector includes a column-line driver for sequentially outputting to the column lines signals that rise in response to a first voltage and then fall in response to a second voltage; a row-voltage outputter, provided for each of the column lines, for outputting a third voltage corresponding to a'current for charging the capacitance at each of the intersections when the column lines are driven by the first voltage and for outputting a fourth voltage corresponding to a current for discharging the capacitance at each of the intersections when the column lines are driven by the second voltage; a holder, provided correspondingly to the row-voltage outputter, for holding the voltage output from the row-voltage outputter; a selector for sequentially selecting outputs from the holder to output the selected outputs; an analog-to-digital converter for converting the outputs from the selector into digital data; and a calculator for storing the digital data supplied from the analog-to-digital converter and calculating the difference between the third voltage and the fourth voltage at each of the intersections of the column lines and the row lines based on the stored data.

With this structure, an output voltage corresponding to a minute capacitance can be provided without a reference voltage, and the data can be efficiently processed in parallel. In addition, a state where a finger is placed on the capacitance detector is reliably detected and the contrast is adjusted when the contrast of the measured data is low, so that a fingerprint can be reliably measured.

The present invention provides, in its fifth aspect, a method of detecting minute capacitances near intersections of a plurality of column lines and a plurality of row lines, used in an area sensor having a matrix of detection lines in which the column lines and the row lines are opposed to each other in a matrix form. The method includes the steps of outputting to the column lines a signal that rises in response to a first voltage and then falls in response to a second voltage; detecting a third voltage corresponding to a current for charging the capacitance at each of the intersections when the column lines are driven by the first voltage and detecting a fourth voltage corresponding to a current for discharging the capacitance at each of the intersections when the column lines are driven by the second voltage; and calculating the difference between the detected third and fourth voltages. The difference between the third voltage and the fourth voltage is calculated at each of the intersections where the column lines intersect with the row lines.

With this method, since the difference between the output voltage at charge and the output voltage at discharge is calculated, the effect of a discharge current caused by feedthrough, which is always superimposed on the capacitances at the intersections at a predetermined direction with respect to the charge and discharge currents, can offset.

Further objects, features, and advantages of the present invention will become apparent from the following description of the preferred embodiments with reference to the attached drawings.

BRIEF DESCRIPTION OF THE DRAWINGS

Fig. 1 is a block diagram showing the structure of a capacitance detector according to a first embodiment of the present invention;
Fig. 2A is a plan view of an area sensor;
Fig. 2B is a cross-sectional view of the area sensor;
Fig. 3 illustrates the operation of a pressure-sensitive area fingerprint sensor;
Fig. 4 is a conceptual diagram showing a capacitance matrix of column lines and row lines of the area sensor;
Fig. 5 is a circuit diagram showing the configuration of a switched capacitor circuit in the capacitance detector of the first embodiment;
Figs. 6A to 6D are timing charts of a detection signal and control signals supplied from the switched capacitor circuit according to the first embodiment;
Figs. 7A to 7F are timing charts of control signals supplied from a selector and the column lines according to the first embodiment;
Fig. 8 is a flowchart showing a process of correcting offset according to a second embodiment of the present invention;
Fig. 9 is a block diagram showing the structure of a capacitance detector according to a third embodiment;
Fig. 10 is a flowchart showing a process of adjusting a gain level according to the third embodiment; and
Fig. 11 is a block diagram showing the structure of a capacitance detector according to a fourth embodiment.

DESCRIPTION OF THE PREFERRED EMBODIMENTS

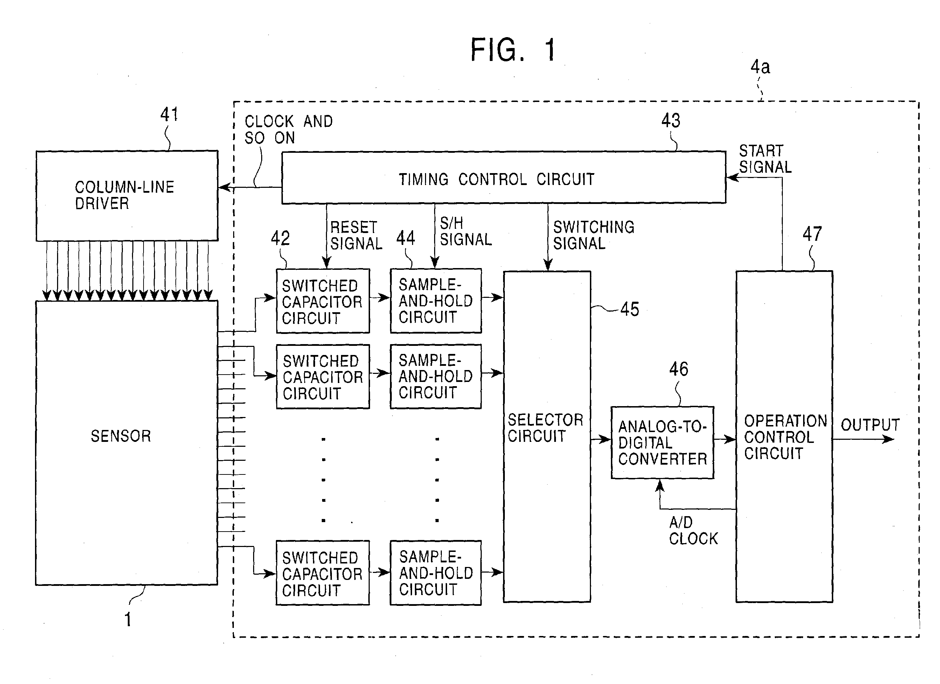

A first embodiment of the present invention will now be described with reference to Figs. 1 to 7.
Fig. 1 is block diagram showing the structure of a capacitance detector 4a of the first embodiment. Referring to Fig. 1, a column-line driver 41 (column-line driving means) sequentially outputs signals that rise and fall at predetermined voltages to column lines of a sensor 1. While the column-line driver 41 does not output a signal, it maintains a ground potential. The signals output through row lines of the sensor 1 are supplied to the capacitance detector 4a.

When the capacitance detector 4a receives the output signals from the sensor 1, it detects a capacitance at each intersection of the column lines and the row lines. Internal functions of the capacitance detector 4a will now be described. A switched capacitor circuit 42 is connected to each row line. The switched capacitor circuit 42 outputs a voltage corresponding to a capacitance of each intersection of the row line connected thereto. Each sample-and-hold circuit 44 holds the signal output from the corresponding switched capacitor circuit 42 and outputs the held signal to a selector circuit 45. The selector circuit 45 selectively and sequentially outputs the signal from the sample-and-hold circuits 44 to an analog-to-digital converter 46 in accordance with a switching signal supplied from a timing control circuit 43. The analog-to-digital converter 46 converts the input signal into a digital signal and outputs the digital signal to an operation control circuit 47. The operation control circuit 47 sequentially stores the data output from the analog-to-digital converter 46 in a memory provided therein and, then, calculates the capacitance at each intersection of the column lines and the row lines of the sensor 1 based on the stored data to output the calculated result. The timing control circuit 43 performs timing control of each component in the capacitance detector 4a.

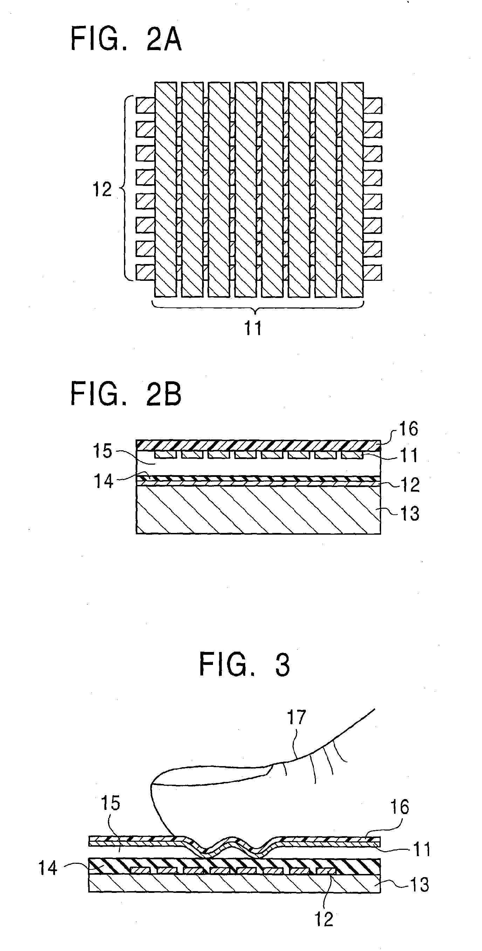

Fig. 2A is a plan view of the sensor 1 and Fig. 2B is a cross-sectional view thereof. Referring to Fig. 2A, column lines 11 and row lines 12 arranged at, for example, a pitch of 50 µm intersect with each other. Referring to Fig. 2B, a substrate 13 has the row lines 12 provided thereon. An insulating film 14 is layered on the row lines 12 that are covered with a film 16 with a gap 15 provided therebetween. The column lines 11 are attached beneath the film 16. Capacitances are generated near the intersections of the column lines 11 and the row lines 12 with the gap 15 and the insulating film 14 disposed therebetween.

When a finger 17 is placed on the sensor 1, the film 16 and the column lines 11 are deformed and the shape of the gap 15 is varied due to the ridges and valleys of the finger 17, as shown in Fig. 3. Accordingly, the capacitances generated near the intersections of the column lines 11 and the row lines 12 are varied.

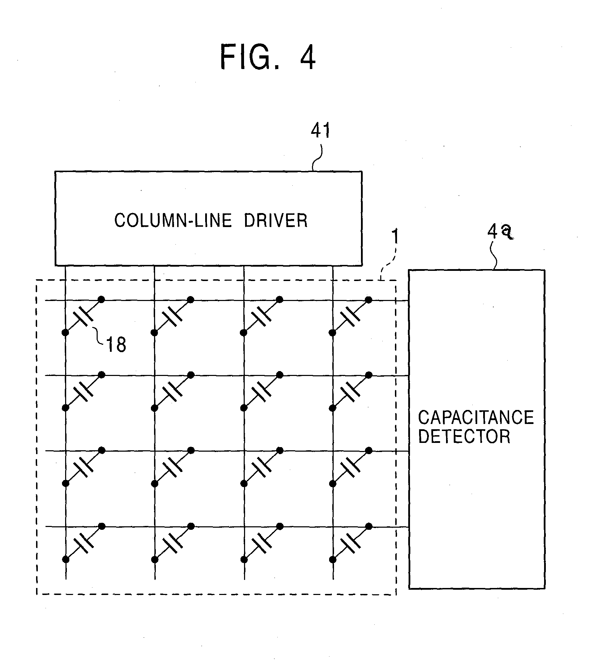

Fig. 4 is a conceptual diagram showing a capacitance matrix of column lines and row lines of the sensor 1. The sensor 1 has a capacitance matrix in which capacitors 18 are arranged in a matrix. The capacitance matrix is connected to the column-line driver 41 and the capacitance detector 4a.

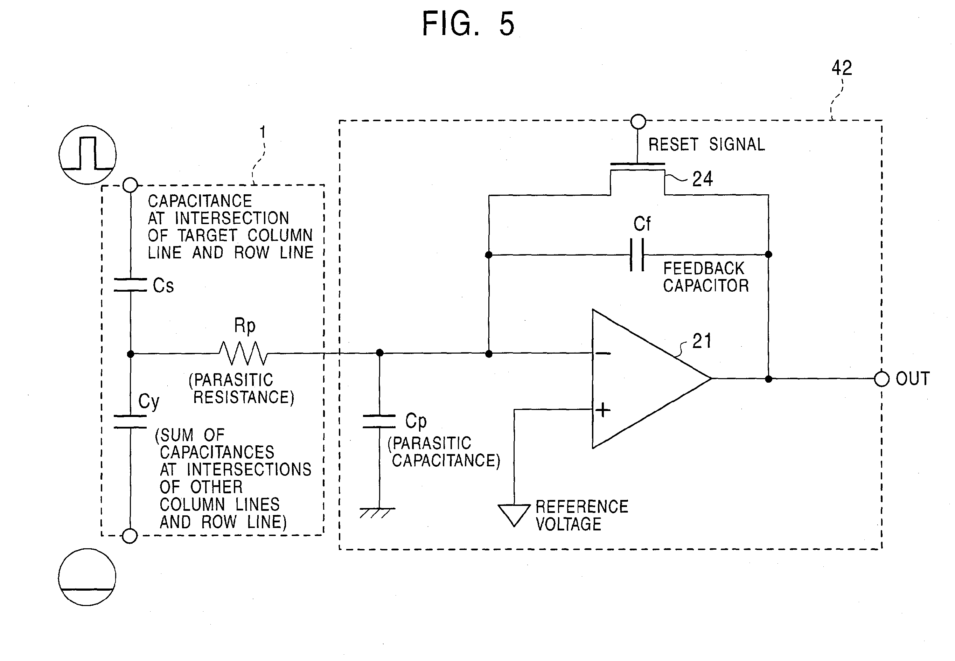

Fig. 5 is a circuit diagram showing the configuration of the switched capacitor circuit 42. Referring to Fig. 5, the switched capacitor circuit 42 includes an operational amplifier 21, a feedback capacitor Cf connected between the inverting input pin and the output pin of the operational amplifier 21, and an analog switch 24 for discharging an electric charge in the feedback capacitor Cf. The noninverting input pin of the operational amplifier 21 is connected to a reference voltage. Reference letter Cp denotes a parasitic capacitance of the operational amplifier 21, reference letter Cs denotes a capacitance at the intersection of a target column line and the corresponding row line, and reference letter Cy denotes a sum of the capacitances at intersections of column lines, other than the target column line, and the corresponding row lines.

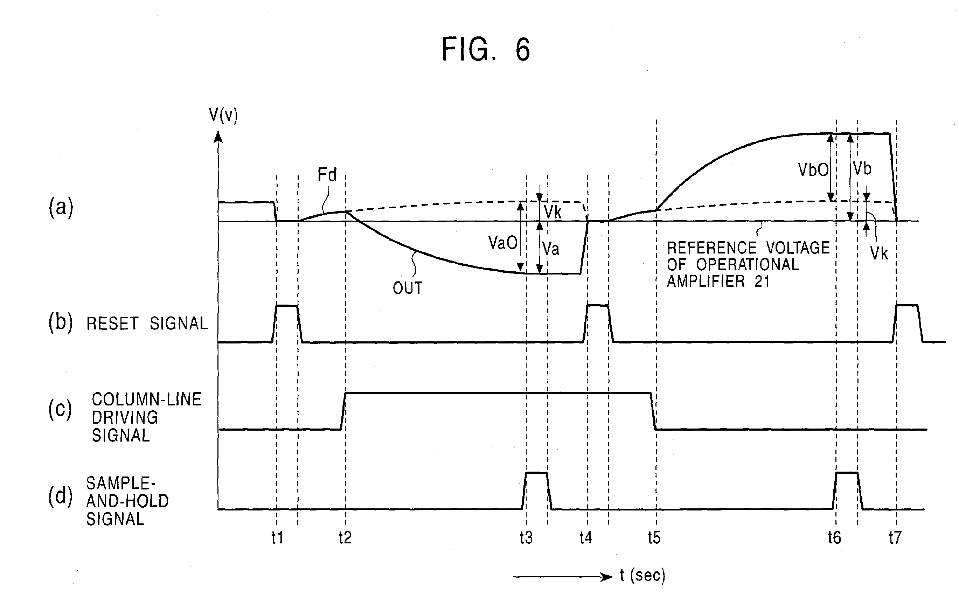

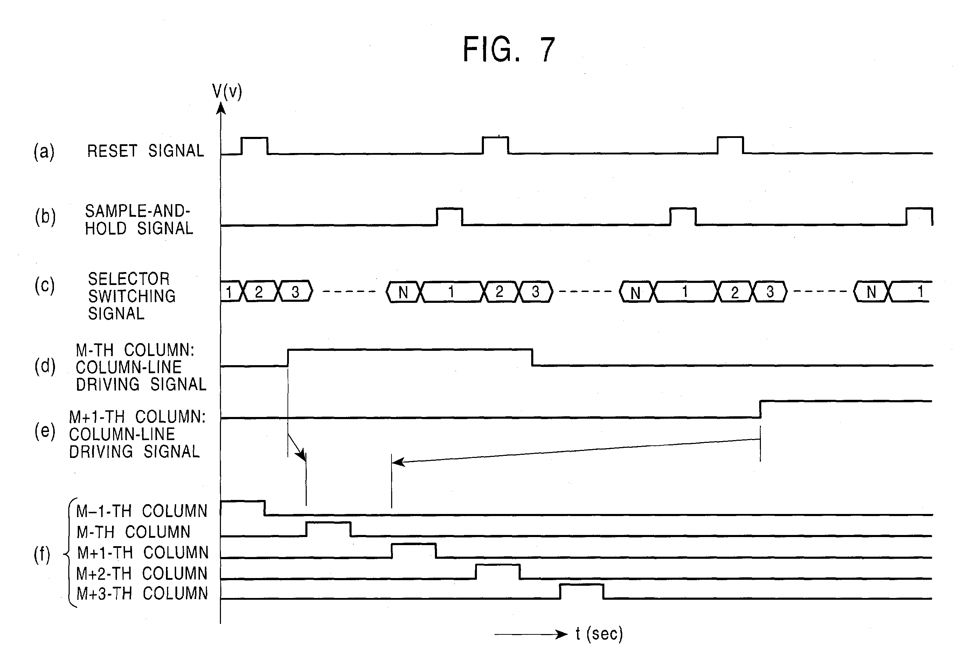

The operation of the circuits shown in Figs. 1 and 5 will now be described with reference to Figs. 6A to 6D and Figs. 7A to 7F.

The column-line driver 41 generates a pulse signal (column-line driving signal) having a predetermined width based on a clock pulse output from the timing control circuit 43, and sequentially applies the generated pulse signal to the first column, the second column, the third column, and so on of the sensor 1 (refer to Fig. 6C and Fig. 7F). The column-line driver 41 simultaneously outputs a ground potential to column lines other than the column line that outputs the pulse signal. The timing control circuit 43 outputs a reset signal to the switched capacitor circuit 42 at a timing slightly before the column-line driving signal rises and at a timing slightly before the column-line driving signal falls, as shown in Fig. 6B and Fig. 7A. Also, the timing control circuit 43 outputs a sample-and-hold signal to the sample-and-hold circuit 44 at a timing slightly before the reset signal is output, as shown in Fig. 6D and Fig. 7B.

The timing control circuit 43 outputs N (N denotes the number of sample-and-hold circuits 44) switching signals to the selector circuit 45 between two sample-and-hold signals. As shown in Fig. 7C, the switching signals held in the sample-and-hold circuit 44 are sequentially supplied to the analog-to-digital converter 46 through the selector circuit 45 during a period from one sample-and-hold signal to the subsequent sample-and-hold signal. The supplied signals are converted into digital data in the analog-to-digital converter 46 and the digital data is stored in the memory in the operation control circuit 47.

The operation of the switched capacitor circuit 42 will now be described. When a reset signal is output from the timing control circuit 43 at a time t1 shown in Figs. 6A to 6D, the analog switch 24 in Fig. 5 is turned on, the electric charge in the feedback capacitor Cf is discharged, and an output OUT from the operational amplifier 21 is set to a reference voltage. Then, when the reset signal is turned off, the output voltage from the operational amplifier 21 slightly increases due to feedthrough caused by a gate parasitic capacitance at the analog switch 24 (shown by reference letter Fd in Fig. 6A). When a column-line driving signal rises at a time t2, the column-line driving signal is applied to the inverting input pin of the operational amplifier 21 through the capacitance Cs at the intersection of the target column line and the corresponding row line, thus gradually decreasing the output OUT from the operational amplifier 21, as shown in Fig. 6A.

When a sample-and-hold signal is output from the timing control circuit 43 at a time t3, a voltage Va of the output OUT from the operational amplifier 21 is held in the sample-and-hold circuit 44. When a reset signal is output again at a time t4, the electric charge in the feedback capacitor Cf is discharged and the output OUT from the operational amplifier 21 returns to the reference voltage. Then, when the reset signal is turned off, the output voltage from the operational amplifier 21 slightly increases due to the feedthrough caused by the gate parasitic capacitance at the analog switch 24, as in the case described above.

When the column-line driving signal falls at a time t5, the electric charge in the capacitance Cs at the intersection of the target column line and the corresponding row line is discharged and the output OUT gradually increases concurrently with the discharge. When a sample-and-hold signal is output from the timing control circuit 43 at a time t6, a voltage Vb of the output OUT from the operational amplifier 21 is held in the sample-and-hold circuit 44. When a reset signal is output at a time t7, the electric charge of feedback capacitor Cf is discharged and the output OUT from the operational amplifier 21 returns to the reference voltage. The steps described above are repeated.

In the detection described above, an offset Vk caused by a feedthrough current of the analog switch 24 is generated in the positive direction when the output OUT decreases below the reference voltage and when the output OUT increases above the reference voltage. When the capacitance Cs to be detected is several tens to several hundreds of femtofarads, as in the first embodiment, the offset Vk caused by the feedthrough current cannot be ignored. A voltage Va0 in proportion to the capacitance Cs to be detected is obtained by Va0 = -Va + Vk in the detection described above, and a voltage Va to be detected is obtained by Va = -Va0 + Vk, which contains an error caused by the offset Vk. Hence, a voltage Vb at discharge of the electric charge in the capacitance Cs to be detected is also detected in the first embodiment. A voltage Vb0 in proportion to the capacitance Cs is obtained by Vb0 = Vb - Vk. Accordingly, the voltage Vb to be detected is obtained by Vb = Vb0 + Vk. These voltages Va and Vb are held in the sample-and-hold circuit 44, the held voltages are converted into digital data by the analog-to-digital converter 46, and the converted data is stored in the memory in the operation control circuit 47. The operation control circuit 47 performs the following operation to acquire a detection value not including an offset error.

[Formula 1]

$$Vb - Va = (Vb0 + Vk) - (Vk + Va0) = Vb0 - Va0$$

As described above, according to the first embodiment, the capacitance can be detected without the effect of the feedthrough by calculating the difference between the output signal from the switched capacitor circuit when the voltage of the corresponding column line rises and the output signal therefrom when the voltage of the corresponding column line falls. The provision of the selector circuit allows the detection of the capacitances of the switched capacitor circuits, which usually requires a lot of time, to be performed in parallel, thus increasing the measurement speed of the overall sensor.

A second embodiment of the present invention will now be described.

Since the sensor 1 of the first embodiment has no reference data, detected values may vary when the structure of the sensor 1 is changed, particularly, when the structure of the sensor 1 is changed due to the variation in capacitance without a finger being pressed on the sensor 1. Accordingly, offset correction data is prepared in advance in the second embodiment.

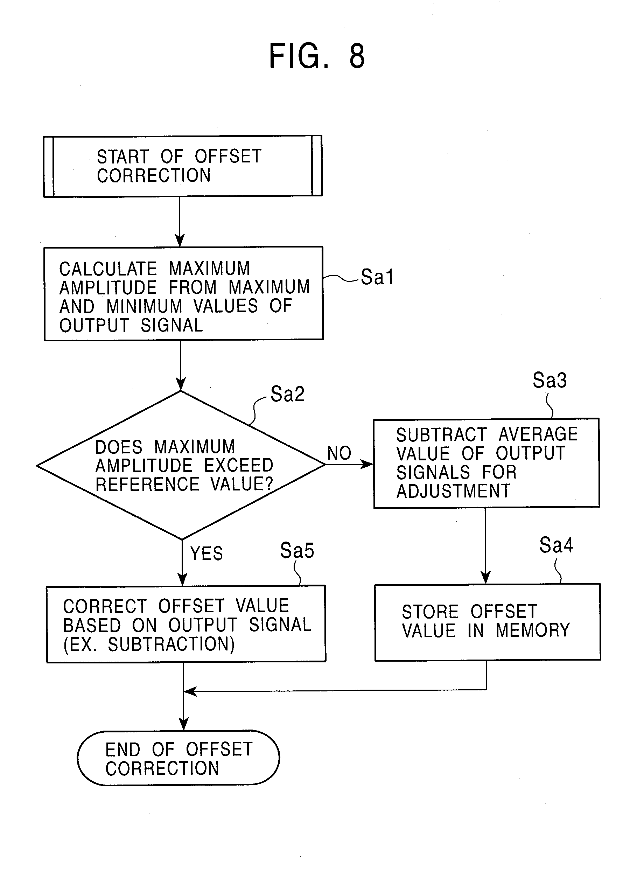

Fig. 8 is a flowchart showing a process of correcting offset according to the second embodiment. Referring to Fig. 8, after the detection at all the intersections is completed and results of the operations described above are obtained, in Step Sa1, the process calculates a maximum amplitude from the maximum and minimum values among the detected values at all the intersections. In Step Sa2, the process determines whether the calculated maximum amplitude exceeds a reference value set in advance. If the determination is negative, the process determines that the detection is performed without a finger being pressed on the sensor 1, and calculates an average value of the detected values. In Step Sa3, the process subtracts the average value from each detected value to calculate an offset value. In Step Sa4, the process stores the offset value in a memory. In contrast, if the maximum amplitude calculated from the maximum and minimum values among the detected values at all the intersections exceeds the reference value set in advance in Step Sa2, the process determines that the detection is performed with a finger being pressed on the sensor 1 and, in Step Sa5, subtracts the offset value in the memory from the detected value to calculate a detection value after correction.

When an offset value cannot be measured in the offset correction because a finger is placed on an area sensor since the area sensor was turned on, the process determines that a finger has been placed on the area sensor since the area sensor was turned on based on a detected value that exceeds a reference value when the area sensor was turned on. In this case, the detected value is not used as the offset value. An offset value that was measured at the previous power-up time is stored in a non-volatile memory and the stored value is used as an offset value at the subsequent power-up time.

As described above, according to the second embodiment, using offset correction data that has been prepared in advance to correct detected values enables stable detection of capacitances.

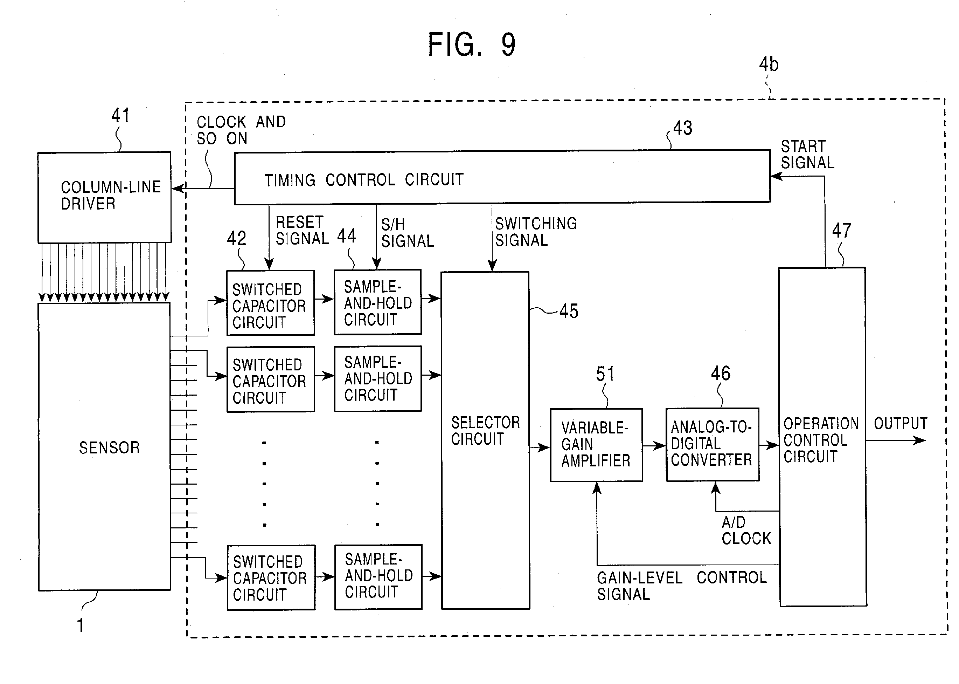

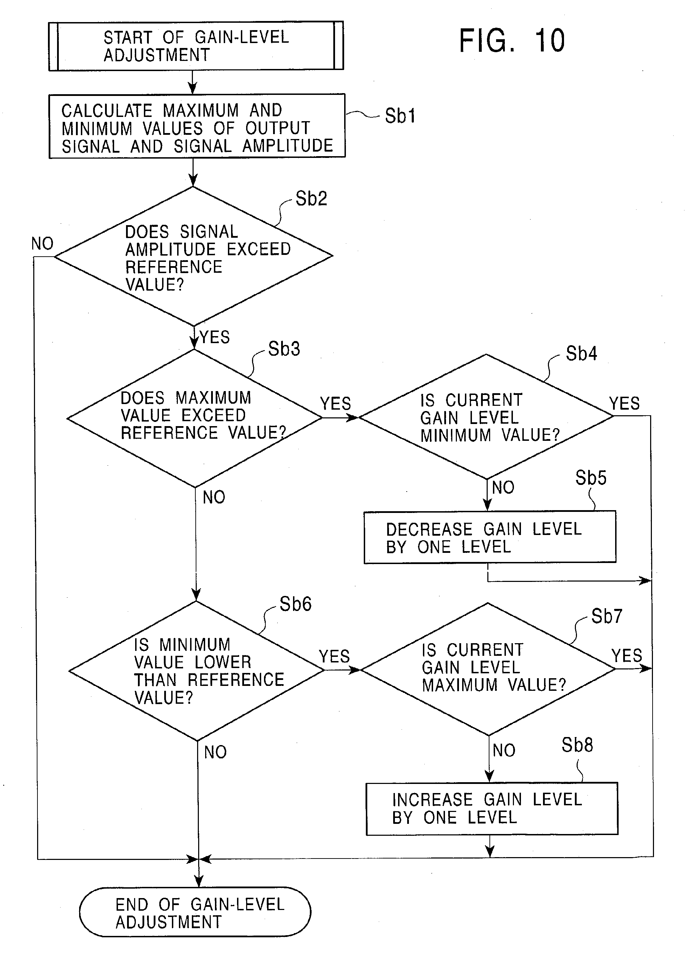

A third embodiment of the present invention will now be described with reference to Figs. 9 and 10.

Fig. 9 is a block diagram showing the structure of a capacitance detector 4b of the third embodiment. Referring to Fig. 9, the column-line driver 41 and the sensor 1 are the same as in the first embodiment shown in Fig. 1. However, the capacitance detector 4b of the third embodiment differs from the capacitance detector 4a of the first embodiment in that the capacitance detector 4b further includes a variable-gain amplifier 51 provided between the selector circuit 45 and the analog-to-digital converter 46. The gain level of the variable-gain amplifier 51 is adjusted based on a gain-level control signal output from the operation control circuit 47. As a characteristic of a fingerprint sensor, as long as the level of data at peaks can be determined relatively to the level of data at troughs, any difference in the absolute level of data causes no problem. Accordingly, the function of adjusting the gain level is provided for the purpose of increasing the gain level of the variable-gain amplifier 51 to enhance the contrast of the detected data so that the difference in the level of data between peaks and troughs can be distinguished even when the absolute level of measured data is reduced due to, for example, the pressure caused by a finger that is pressed on the sensor.

Fig. 10 is a flowchart showing a process of adjusting a gain level in the operation control circuit 47 and the variable-gain amplifier 51. The operation of the capacitance detector 4b according to the third embodiment will now be described with reference to Fig. 10.

In Step Sb1, the process calculates maximum and minimum values of an output signal and a signal amplitude. In Step Sb2, the process determines whether the signal amplitude exceeds a reference value. If the determination is negative, the process determines that there is no need to adjust the gain level and the process of adjusting the gain level is finished. If the determination is positive in Step Sb2, then in Step Sb3, the process determines whether the maximum value exceeds a reference value. If the determination is positive, in Step Sb4, the process determines whether the current gain level is a minimum value. If the determination is negative, in Step Sb5, the process decreases the gain level by one level and the process of adjusting the gain level is finished. If the determination is positive in Step Sb4, the process of adjusting the gain level is finished because the gain level cannot be decreased. If the determination is negative in Step Sb3, then in Step Sb6, the process determines whether the minimum value is lower than a reference value. If the determination is positive, in Step Sb7, the process determines whether the current gain level is a maximum value. If the determination is negative, in Step Sb8, the process increases the gain level by one level and the process of adjusting the gain level is finished. If the determination is positive in Step Sb7, the process of adjusting the gain level is finished because the gain level cannot be increased. If the determination is negative in Step Sb6, the process of adjusting the gain level is finished.

In the adjustment of the gain level, a state in which a finger is not placed on the sensor may be detected to fix the gain level.

As described above, according to the third embodiment, adjusting the gain level of the amplifier even when a finger is pressed with a low pressure and the level of detected output is low in a sensor where the contrast of data between peaks and troughs is important allows the contrast of data between peaks and troughs to be enhanced.

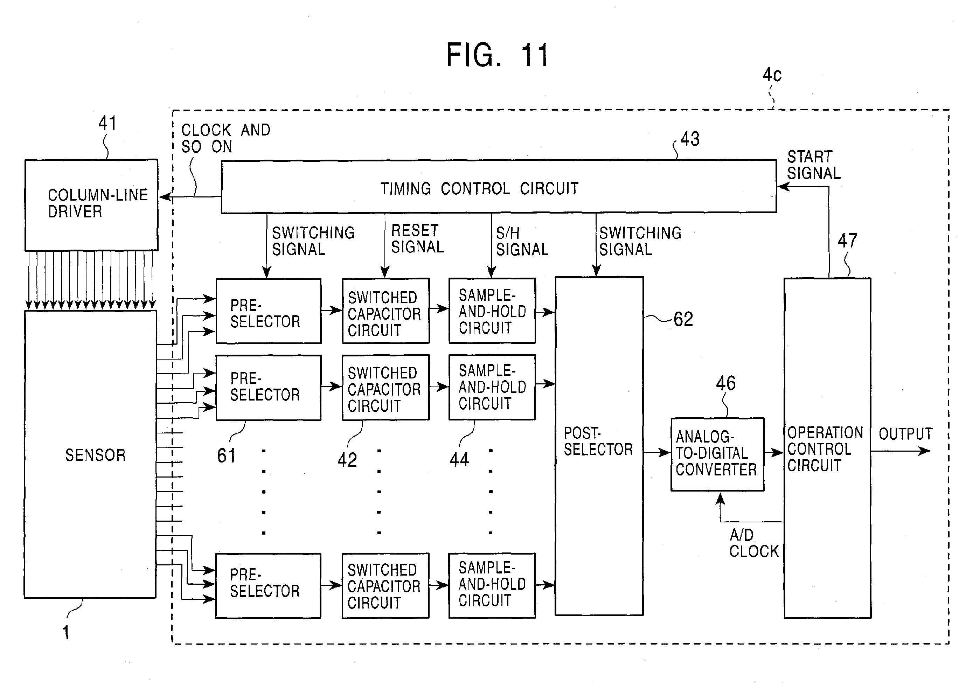

A fourth embodiment will now be described with reference to Fig. 11.

Fig. 11 a block diagram showing the structure of a capacitance detector 4c of the fourth embodiment. Referring to Fig. 11, the column-line driver 41 and the sensor 1 are the same as in the first embodiment shown in Fig. 1. However, the capacitance detector 4c of the fourth embodiment differs from the capacitance detector 4a of the first embodiment in that the capacitance detector 4c further includes preselectors 61 each provided between the input pin of the corresponding switched capacitor circuit 42 and the sensor 1 and a postselector 62 provided between the sample-and-hold circuits 44 and the analog-to-digital converter 46 in order to decrease the number of the switched capacitor circuits 42 and the sample-and-hold circuits 44. The operation of the capacitance detector 4c according to the fourth embodiment will now be described.

The operation of the capacitance detector 4c according to the fourth embodiment is basically the same as in the first embodiment. However, the order of measuring the row lines ,is different from that in the first embodiment and the timing control circuit 43 outputs a control signal to each component in synchronization with the measurement. For example, when the number of input channels of the preselector 61 is P, one of the switched capacitor circuits 42 and one of the sample-and-hold circuits 44 detects the capacitances of the capacitors connected to P number of row lines. Specifically, the first row line is selected among the P number of row lines connected to one of the preselectors 61 to detect the capacitance, and the detection is repeated for the second to P-th row lines. The postselector 62 operates equivalently to the selector circuit 45 of the first embodiment.

As described above, according to the fourth embodiment, dividing the selector circuit into the preselectors and the postselector can decrease the number of the switched capacitor circuits and the sample-and-hold circuits.

As described above, according to the present invention, a minute change in capacitance can be reliably detected.

## Claims

1. A capacitance detector, used in an area sensor having a matrix of detection lines in which a plurality of column lines and a plurality of row lines are opposed to each other in a matrix form, for detecting minute capacitances near intersections of the column lines and the row lines, the capacitance detector comprising:

   a column-line driver for outputting to the column lines a signal that rises in response to a first voltage and then falls in response to a second voltage;
   a row-voltage outputter for outputting a third voltage corresponding to a current for charging the capacitance at each of the intersections when the column lines are driven by the first voltage and for outputting a fourth voltage corresponding to a current for discharging the capacitance at each of the intersections when the column lines are driven by the second voltage; and
   a calculator for calculating the difference between the third voltage and the fourth voltage output from the row-voltage outputter,

   wherein the difference between the third voltage and the fourth voltage is calculated at each of the intersections where the column lines intersect with the row lines.

2. A capacitance detector, used in an area sensor having a matrix of detection lines in which a plurality of column lines and a plurality of row lines are opposed to each other in a matrix form, for detecting minute capacitances near intersections of the column lines and the row lines, the capacitance detector comprising:

   a column-line driver for sequentially outputting to the column lines signals that rise in response to a first voltage and then fall in response to a second voltage;
   a row-voltage outputter, provided for each of the column lines, for outputting a third voltage corresponding to a current for charging the capacitance at each of the intersections when the column lines are driven by the first voltage and for outputting a fourth voltage corresponding to a current for discharging the capacitance at each of the intersections when the column lines are driven by the second voltage;
a holder, provided correspondingly to the row-voltage outputter, for holding the voltage output from the row-voltage outputter;
a selector for sequentially selecting outputs from the holder to output the selected outputs;
an analog-to-digital converter for converting the outputs from the selector into digital data; and
a calculator for storing the digital data supplied from the analog-to-digital converter and calculating the difference between the third voltage and the fourth voltage at each of the intersections of the column lines and the row lines based on the stored data.

3. The capacitance detector according to Claim 1, further comprising:

   a maximum-value finder for finding a maximum value in the third and fourth voltages detected at the intersections;
   a reference setter for setting the difference between the third voltage and the fourth voltage at each of the intersections as a reference voltage in a storage unit if the maximum value found by the maximum-value finder is smaller than a predetermined value set in advance; and
   a corrector for subtracting the reference voltage in the storage unit from the difference between the third voltage and the fourth voltage at each of the intersections and for outputting the subtraction result as data after offset correction.

4. The capacitance detector according to Claim 1, further comprising:

   a maximum-value finder for finding a maximum value in the third and fourth voltages detected at the intersections;
   an amplifier for amplifying the third voltage and the fourth voltage at each of the intersections and outputting the amplified voltage; and
   a gain adjuster for increasing a gain for use in amplifying the third voltage and the fourth voltage at each of the intersections if the maximum value found by the maximum-value finder is smaller than a predetermined value set in advance and for decreasing the gain for use in amplifying the third voltage and the fourth voltage at each of the intersections if the maximum value found by the maximum-value finder is larger than another predetermined value set in advance.

5. A fingerprint sensor including a capacitance detector used in an area sensor having a matrix of detection lines in which a plurality of column lines and a plurality of row lines are opposed to each other in a matrix form, the capacitance detector detecting minute capacitances near intersections of the column lines and the row lines and the capacitance detector comprising:

a column-line driver for outputting to the column lines a signal that rises in response to a first voltage and then falls in response to a second voltage;

a row-voltage outputter for outputting a third voltage corresponding to a current for charging the capacitance at each of the intersections when the column lines are driven by the first voltage and for outputting a fourth voltage corresponding to a current for discharging the capacitance at each of the intersections when the column lines are driven by the second voltage; and

a calculator for calculating the difference between the third voltage and the fourth voltage output from the row-voltage outputter,

wherein the difference between the third voltage and the fourth voltage is calculated at each of the intersections where the column lines intersect with the row lines.

6. A fingerprint sensor including a capacitance detector used in an area sensor having a matrix of detection lines in which a plurality of column lines and a plurality of row lines are opposed to each other in a matrix form, the capacitance detector detecting minute capacitances near intersections of the column lines and the row lines and the capacitance detector comprising:

a column-line driver for sequentially outputting to the column lines signals that rise in response to a first voltage and then fall in response to a second voltage;

a row-voltage outputter, provided for each of the column lines, for outputting a third voltage corresponding to a current for charging the capacitance at each of the intersections when the column lines are driven by the first voltage and for outputting a fourth voltage corresponding to a current for discharging the capacitance at each of the intersections when the column lines are driven by the second voltage;

a holder, provided correspondingly to the row-voltage outputter, for holding the voltage output from the row-voltage outputter;

a selector for sequentially selecting outputs from the holder to output the selected outputs;

an analog-to-digital converter for converting the outputs from the selector into digital data; and

a calculator for storing the digital data supplied from the analog-to-digital converter and calculating the difference between the third voltage and the fourth voltage at each of the intersections of the column lines and the row lines based on the stored data.

7. A method of detecting minute capacitances near intersections of a plurality of column lines and a plurality of row lines, used in an area sensor having a matrix of detection lines in which the column lines and the row lines are opposed to each other in a matrix form, the method comprising the steps of:

outputting to the column lines a signal that rises in response to a first voltage and then falls in response to a second voltage;

detecting a third voltage corresponding to a current for charging the capacitance at each of the intersections when the column lines are driven by the first voltage and detecting a fourth voltage corresponding to a current for discharging the capacitance at each of the intersections when the column lines are driven by the second voltage; and

calculating the difference between the detected third and fourth voltages,

wherein the difference between the third voltage and the fourth voltage is calculated at each of the intersections where the column lines intersect with the row lines.

# FIG. 1

COLUMN-LINE DRIVER — 41

CLOCK AND SO ON

TIMING CONTROL CIRCUIT — 43

START SIGNAL

4a

SENSOR — 1

RESET SIGNAL

S/H SIGNAL

SWITCHING SIGNAL

SWITCHED CAPACITOR CIRCUIT — 42

SAMPLE-AND-HOLD CIRCUIT — 44

SWITCHED CAPACITOR CIRCUIT

SAMPLE-AND-HOLD CIRCUIT

SELECTOR CIRCUIT — 45

ANALOG-TO-DIGITAL CONVERTER — 46

OPERATION CONTROL CIRCUIT — 47

OUTPUT

A/D CLOCK

SWITCHED CAPACITOR CIRCUIT

SAMPLE-AND-HOLD CIRCUIT

EP 1 503 324 A1

## FIG. 2A

## FIG. 2B

## FIG. 3

# FIG. 4

41

COLUMN-LINE DRIVER

1

4a

CAPACITANCE DETECTOR

18

FIG. 5

42

RESET SIGNAL

24

Cf

FEEDBACK CAPACITOR

21

OUT

REFERENCE VOLTAGE

Cp (PARASITIC CAPACITANCE)

1

CAPACITANCE AT INTERSECTION OF TARGET COLUMN LINE AND ROW LINE

Cs

Rp (PARASITIC RESISTANCE)

Cy (SUM OF CAPACITANCES AT INTERSECTIONS OF OTHER COLUMN LINES AND ROW LINE)

FIG. 6

# FIG. 7

EP 1 503 324 A1

# FIG. 8

START OF OFFSET
CORRECTION

CALCULATE MAXIMUM
AMPLITUDE FROM MAXIMUM
AND MINIMUM VALUES OF
OUTPUT SIGNAL — Sa1

DOES MAXIMUM
AMPLITUDE EXCEED
REFERENCE VALUE? — Sa2

NO →

Sa3
SUBTRACT AVERAGE
VALUE OF OUTPUT
SIGNALS FOR
ADJUSTMENT

YES      Sa5

CORRECT OFFSET VALUE
BASED ON OUTPUT SIGNAL
(EX. SUBTRACTION)

Sa4
STORE OFFSET
VALUE IN MEMORY

END OF OFFSET
CORRECTION

# FIG. 9

EP 1 503 324 A1

FIG. 10

```
┌─────────────────────────────┐
│   START OF GAIN-LEVEL       │
│   ADJUSTMENT                │
└─────────────────────────────┘
              │
              ▼
┌─────────────────────────────┐
│ CALCULATE MAXIMUM AND       │──── Sb1
│ MINIMUM VALUES OF OUTPUT    │
│ SIGNAL AND SIGNAL AMPLITUDE │
└─────────────────────────────┘
              │
              ▼
         Sb2
        ╱ DOES SIGNAL ╲
  NO   ╱  AMPLITUDE EXCEED ╲
◄─────╱   REFERENCE          ╲
       ╲  VALUE?             ╱
        ╲                   ╱
              │ YES
              ▼
         Sb3                         Sb4
        ╱ DOES MAXIMUM ╲   YES     ╱ IS CURRENT ╲    YES
       ╱  VALUE EXCEED  ╲─────────╱  GAIN LEVEL  ╲─────────►
       ╲  REFERENCE VALUE? ╱      ╲  MINIMUM VALUE? ╱
        ╲                ╱         ╲              ╱
              │ NO                      │ NO      Sb5
              │                         ▼
              │              ┌─────────────────────────────┐
              │              │ DECREASE GAIN LEVEL         │
              │              │ BY ONE LEVEL               │
              │              └─────────────────────────────┘
              │                         │
              ▼                         │
         Sb6                         Sb7
        ╱ IS MINIMUM ╲     YES     ╱ IS CURRENT ╲    YES
       ╱  VALUE LOWER  ╲─────────╱  GAIN LEVEL  ╲─────────►
       ╲  THAN REFERENCE ╱       ╲  MAXIMUM VALUE? ╱
        ╲  VALUE?       ╱         ╲              ╱
              │ NO                      │ NO      Sb8
              │                         ▼
              │              ┌─────────────────────────────┐
              │              │ INCREASE GAIN LEVEL         │
              │              │ BY ONE LEVEL               │
              │              └─────────────────────────────┘
              │                         │
              ▼◄────────────────────────┘
    ┌─────────────────────────┐
    │  END OF GAIN-LEVEL      │
    │  ADJUSTMENT             │
    └─────────────────────────┘
```

18

FIG. 11

European Patent

Office

**EUROPEAN SEARCH REPORT**

Application Number

EP 04 25 4387

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,Y | EP 0 715 153 A (NIPPON ELECTRIC CO) 5 June 1996 (1996-06-05) * column 4, line 10 - column 7, line 49; figures 3,8 * | 1,2,4-7 | G06K9/00 |
| Y | WO 03/008899 A (SHINOZAKI KEIICHI ; SONY CORP (JP); YANO MOTOYASU (JP); YOSHIOKA MASAK) 30 January 2003 (2003-01-30) * abstract; figure 3 * | 1,2,4-7 | |
| P,Y | US 2003/174871 A1 (SHINOZAKI KEIICHI ET AL) 18 September 2003 (2003-09-18) English language text, published after the priority date, cited as presumably valid translation of the above japanese international application WO 03/008899, published before the priority date. * paragraphs [0003] - [0069]; figures 1-3,7 * | 1,2,4-7 | |
| A | US 4 353 056 A (TSIKOS CONSTANTINE) 5 October 1982 (1982-10-05) * abstract; figures 7,9 * | | **TECHNICAL FIELDS SEARCHED (Int.Cl.7)** G06K |
| A | DE 198 33 210 A (SIEMENS AG) 17 February 2000 (2000-02-17) * abstract; figures 1,2 * | 1-7 | |

-/--

The present search report has been drawn up for all claims

| Place of search | Date of completion of the search | Examiner |
|---|---|---|
| Munich | 12 October 2004 | Feron, M |

EPO FORM 1503 03.82 (P04C01)

## EUROPEAN SEARCH REPORT

**European Patent**
**Office**

**Application Number**

EP 04 25 4387

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | REY P ET AL: "A high density capacitive pressure sensor array for fingerprint sensor application" 1997 INTERNATIONAL CONFERENCE ON SOLID-STATE SENSORS AND ACTUATORS. DIGEST OF TECHNICAL PAPERS. TRANSDUCERS 97. CHICAGO, IL, JUNE 16 - 19, 1997. SESSIONS 3A1 - 4D3. PAPERS NO. 3A1.01 - 4D3.14P, INTERNATIONAL CONFERENCE ON SOLID-STATE SENSORS AND ACTU, vol. VOL. 2, 16 June 1997 (1997-06-16), pages 1453-1456, XP010240759 ISBN: 0-7803-3829-4 * the whole document * ----- | 1-7 | |
| | | | **TECHNICAL FIELDS SEARCHED** (Int.Cl.7) |

The present search report has been drawn up for all claims

| Place of search | Date of completion of the search | Examiner |
|---|---|---|
| Munich | 12 October 2004 | Feron, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 04 25 4387

This annex lists the patent family members relating to the patent documents cited in the above-mentioned European search report.
The members are as contained in the European Patent Office EDP file on
The European Patent Office is in no way liable for these particulars which are merely given for the purpose of information.

12-10-2004

| Patent document cited in search report | | Publication date | Patent family member(s) | | Publication date |
|---|---|---|---|---|---|
| EP 0715153 | A | 05-06-1996 | JP | 2561040 B2 | 04-12-1996 |
| | | | JP | 8145717 A | 07-06-1996 |
| | | | DE | 69500956 D1 | 04-12-1997 |
| | | | DE | 69500956 T2 | 28-05-1998 |
| | | | EP | 0715153 A1 | 05-06-1996 |
| | | | US | 5633594 A | 27-05-1997 |
| WO 03008899 | A | 30-01-2003 | JP | 2003028606 A | 29-01-2003 |
| | | | EP | 1406058 A1 | 07-04-2004 |
| | | | WO | 03008899 A1 | 30-01-2003 |
| | | | US | 2003174871 A1 | 18-09-2003 |
| US 2003174871 | A1 | 18-09-2003 | JP | 2003028606 A | 29-01-2003 |
| | | | EP | 1406058 A1 | 07-04-2004 |
| | | | WO | 03008899 A1 | 30-01-2003 |
| US 4353056 | A | 05-10-1982 | DE | 3172656 D1 | 21-11-1985 |
| | | | EP | 0041693 A1 | 16-12-1981 |
| DE 19833210 | A | 17-02-2000 | DE | 19833210 A1 | 17-02-2000 |

EPO FORM P0459

For more details about this annex : see Official Journal of the European Patent Office, No. 12/82